# EUROPÄISCHE PATENTANMELDUNG

(11) **EP 2 620 752 A2**
(43) Veröffentlichungstag der Anmeldung: **31.07.2013**
(21) Anmeldenummer: 13000398.1
(22) Anmeldetag: 28.01.2013
(51) Int. Cl.: G01D 5/14

(54) **Magnetfeldsensor**

(30) Priorität: 27.01.2012 DE 102012001501; 07.02.2012 DE 102012002204
(71) Anmelder: Mehnert, Walter, 85521 Ottobrunn (DE); Theil, Thomas, Dr., 82340 Feldafing (DE)
(72) Erfinder: Mehnert, Walter, 85521 Ottobrunn (DE); Theil, Thomas, Dr., 82340 Feldafing (DE)
(74) Vertreter: Strasser, Wolfgang

(57) **Zusammenfassung**

Ein Magnetfeldsensor für einen Positionsgeber, der eine Verarbeitungs- und Steuerelektronik für die Ausgangssignale des Magnetfeldsensors und eine Erreger-Permanentmagnetanordnung (2; 11; 12) umfasst, weist wenigstens drei Hallelemente (6) auf, mit deren Hilfe die Magnetfeldrichtung der Permanentmagnetanordnung erfasst werden soll. Die Hallelemente sind mit gegenseitigen Abständen in einem Halbleiter-IC (5) so ausgebildet und angeordnet, dass ihre aktiven Flächen in einer gemeinsamen, zur Oberfläche des Halbleiter-ICs parallelen Ebene liegen. Es ist ein einziger, aus einem ferromagnetischen Material bestehenden Umlenkkörper (4) vorgesehen und so angeordnet, dass von der Permanentmagnetanordnung ausgehende Feldlinien, die ohne den Umlenkkörper parallel zur gemeinsamen Ebene der aktiven Flächen der Hallelemente verlaufen würden, zumindest eine Richtungskomponente erhalten, welche diese aktiven Flächen senkrecht durchstößt: Der Umlenkkörper (4) ist als eigenständiges Bauteil getrennt vom Halbleiter-IC (5) gefertigt und montiert und die gegenseitigen Abstände der Hallelemente auf der Oberfläche des Halbleiter-ICs betragen ein Vielfaches der maximalen Ausdehnung der Hallelemente selbst.

## Beschreibung

Die Erfindung betrifft einen Magnetfeldsensor der im Oberbegriff von Anspruch 1 genannten Art.

Als Positionsgeber kommen dabei insbesondere Drehgeber in Frage, mit deren Hilfe die Winkelposition eines sich drehenden Körpers erfasst werden soll, der zu diesem Zweck mit einer Erreger-Permanentenmagnetanordnung drehfest verbunden oder gekoppelt ist, deren Magnetfeld die Drehung des Körpers exakt abbildet. Die momentane Richtung dieses Magnetfeldes wird mit Hilfe von wenigstens drei bezüglich der Drehung des zu überwachenden Körpers feststehend angeordneten Hallelementen erfasst, aus deren Ausgangssignalen wenigstens zwei in etwa periodische Mess-Signale abgeleitet werden, die gegeneinander phasenverschoben sind, um die jeden einzelnen dieser beiden Signale anhaftende Mehrdeutigkeit zu eliminieren.

Aus der EP 1 182 461 A1 sind für diesen Zweck verwendbare Magnetfeldsensoren bekannt, bei denen die Hallelemente in einem Halbleiter-IC so ausgebildet sind, dass ihre aktiven Flächen in einer gemeinsamen, zu einer der ebenen Oberflächen des Halbleiter-ICs parallelen Fläche liegen. In vielen Anwendungsfällen ist es aus baulichen Gründen zweckmäßig, die Erreger-Permanentenmagnetanordnung so auszurichten, dass ihre Magnetisierungsrichtung sich in einer zu der von den aktiven Flächen der Hallelemente parallelen Fläche bewegt. Damit deren aktiven Flächen dennoch von senkrechten Komponenten des Magnetfeldes durchsetzt werden, ist wenigstens ein Umlenkkörper aus einem ferromagnetischen Material vorgesehen, der so geformt und positioniert ist, dass ein Teil der von der Erreger-Permanentenmagnetanordnung ausgehenden Magnetfeldlinien, die ohne seine Anwesenheit parallel zu den aktiven Flächen der Hallelemente verlaufen würden, diese mit einer senkrechten Komponente durchsetzen.

Bei den aus der oben genannten Druckschrift bekannten Magnetfeldsensoren ergibt sich eine Reihe von Schwierigkeiten, weil davon ausgegangen wird, dass für eine genaue Messung der jeweiligen Winkelposition die wenigstens zwei aus den Ausgangssignalen der Hallelemente abgeleiteten Mess-Signale mit möglichst guter Näherung sinusförmig sein müssen.

Darüber hinaus ist es auch erforderlich, den Einfluss störender Fremdmagnetfelder auf die Mess-Signale weitestgehend zu beseitigen. Dazu werden beim genannten Stand der Technik vier Hallelemente durch eine im Halbleiter-IC vorgenommene feste Verdrahtung paarweise so gegeneinander geschaltet, dass sich die Nutzfeldanteile addieren, während sich die Störfeldanteile voneinander subtrahieren sollen. Letztere sind aber nur dann gleich und heben sich nur dann gegenseitig auf, wenn das Störfeld die beiden Hallelemente eines jeden Paares mit gleicher Stärke und Richtung durchsetzt. Bei jeder Abweichung von dieser Idealbedingung bleibt ein Störfeldanteil erhalten, der umso größer werden kann, je weiter die aktiven Flächen der Hallelemente voneinander entfernt sind.

Außerdem ist es beim genannten Stand der Technik erforderlich, den dort als Feldkonzentrator bezeichneten Umlenkkörper bezüglich der Hallelemente möglichst exakt und symmetrisch zu positionieren, weil als Mess-Signale Sinus/Kosinus-Signale benötigt werden. Dies lässt sich eigentlich nur dadurch erreichen, dass dieser Umlenkkörper mit einer mit der Herstellung von ICs kompatiblen Technologie unmittelbar auf die Oberfläche des ICs aufgebracht wird.

Nachteilig ist dabei, dass nur einige wenige ferromagnetische Materialien geeignet sind, mit einer geringen Schichtdicke aufgebracht zu werden, die in der Größenordnung von 15µm bis 30 µm liegt. Derartig dünne ferromagnetische Körper dürfen aber parallel zur Richtung des umzulenkenden Magnetfeldes nur geringe Abmessungen besitzen, weil sie sonst rasch in die Sättigung getrieben würden.

Die feste Aufbringung des Umlenkkörpers auf die Oberfläche des im Messbetrieb bezüglich des rotierenden Magnetfeldes feststehenden ICs hat weiterhin zur Folge, dass eine ständige Ummagnetisierung stattfindet. Die damit verbundene Hysterese führt zu Fehlern in den Mess-Signalen, die dadurch klein gehalten werden sollen, dass der Umlenkkörper eine geringe Remanenzfeldstärke besitzt. Völlig beseitigen lassen sie sich jedoch auch dann nicht, wenn man magnetische Gläser verwendet, die wiederum nur in dünnen Schichten herstellbar sind.

Aus allen diesen Gründen ist es beim Stand der Technik erforderlich, die Hallelemente auf dem Halbleiter-IC möglichst nahe beieinander zu positionieren, was aber zur Folge hat, dass sie nur einen sehr kleinen Bereich des Magnetfeldes erfassen, wodurch eine besondere Empfindlichkeit gegen Feldinhomogenitäten entsteht. Außerdem erfordert die extrem kleine Bauform, dass das Material des Umlenkkörpers eine große relative Permeabilität µ_{R} besitzt, um eine ausreichend große Feldstärke auf die Hallelemente konzentriert zu erzeugen. Ein großes µ_{R} führt aber bei vergleichbarer Koerzitvfeldstärke zu einer großen Remanenz.

Demgegenüber liegt der Erfindung die Aufgabe zugrunde, einen Magnetfeldsensor der eingangs genannten Art zu schaffen, bei dem alle diese Probleme vermieden werden.

Zur Lösung dieser Aufgabe sieht die Erfindung die im Anspruch 1 zusammengefassten Merkmale vor.

Gemäß der Erfindung werden zwei im Stand der Technik für unabdingbar gehaltene Eigenschaften des Magnetfeldsensor aufgegeben, nämlich die Anordnung des Umlenkkörpers unmittelbar auf der Oberfläche des ICs und damit auch der Zwang, ihn mit Hilfe eines mit der IC-Technologie kompatiblen Verfahrens herzustellen, und die extrem kleinen gegenseitigen Abstände der Hallelemente auf dieser Oberfläche.

Dadurch wird für die Konstruktion des Magnetfeldsensors eine Reihe von vorteilhaften Freiheitsgraden gewonnen.

Der Umlenkkörper kann nicht nur flächenmäßig größer sondern auch wesentlich dicker als beim Stand der Technik ausgebildet werden, wodurch die Gefahr vermindert wird, dass er schnell in die Sättigung gerät. Dies ermöglicht die Verwendung größerer und damit auch stärkerer Permanentenmagnete, sodass der Umlenkkörper aus einem Material hergestellt werden kann, das eine wesentlich kleinere relative Permeabilität µ_{R} als beim Stand der Technik besitzt.

Dadurch, dass für die Herstellung des Umlenkkörpers die Bindung an ein mit der IC-Technologie kompatibles Verfahren aufgegeben wird, können günstigere Materialien wie z.B. die Heußlersche Legierung, Ferrite oder kunststoffgebundene Ferrite verwendet werden, insbesondere solche, die eine niedrige Remanenz und eine kleine Koerzitivkraft besitzen und zu einem geringen Hysteresefehler führen. Ferrite bieten einen weiteren unschätzbaren Vorteil dadurch, dass ihre gemahlenen Körner in der Größenordnung von 2 µm eigenständige Einbereichsteilchen darstellen, die durch den gegebenen magnetischen Aufbau bei rotierendem Magneten nur Hystereserauschen hervorrufen, welches naturgemäß wesentlich kleiner ist als der sonstige Remanenzsprung. Unter Hystereserauschen wird das statistische Auftreten der Remanenzsprünge der einzelnen Körner verstanden.

Ein wesentlicher Gesichtspunkt der Erfindung ist, dass der wegen der größeren Abstände der Hallelemente eine größere Fläche überdeckende Umlenkkörper nicht nur als Feldkonzentrator und Feldsymmetrierer, sondern in gewissem Maße auch als Feldintegrator wirkt, wodurch die Anordnung gegen Feldinhomogenitäten unempfindlicher wird.

Will man zur Erzielung höchster Genauigkeit völlig hysteresefrei messen, so erlaubt es die erfindungsgemäße körperliche Trennung von IC und Umlenkkörper, letzteren so zu montieren, dass er sich mit dem zu überwachenden Körper und damit auch mit der Permanentenmagnetanordnung mitdreht. Das ihn durchsetzende Feld ändert sich daher nicht und es findet keine Ummagnetisierung statt.

Dass durch die erfindungsgemäßen Maßnahmen die Positioniergenauigkeit des Umlenkkörpers bezüglich der Hallelemente verringert wird, wodurch die aus den Signalen der Hallelemente ableitbaren Mess-Signale deutlich stärker von der Sinusform und einem Phasenverschiebungswert von 90° abweichen, ist nur scheinbar nachteilig, weil das aus der DE 10 2010 010 560.0 A1 entnehmbare Verfahren zur Gewinnung und Aufbereitung der Hallelementsignale, das vorzugsweise in Verbindung mit einem erfindungsgemäßen Magnetfeldsensor zur Verwendung kommt, für eine hochgenaue Messung nur die Reproduzierbarkeit halbperiodischer, ansonsten aber eigentlich beliebiger Sensorsignale, aber nicht mehr deren möglichst exakten sinusförmigen Verlauf, und schon gar nicht deren Phasenverschiebung um 90° benötigt. Stattdessen wird dort der Sensor nur als Adressgeber verwendet, dessen Speicher in einem mit Hilfe eines hochgenauen Positions-Eichnormals durchgeführten Eichlauf mit den exakten Messwerten geladen wird. Der technische Gehalt der DE 10 2010 010 560.0 A1 wird hier durch Bezugnahme in vollem Umfang mit aufgenommen.

Die Erfindung wird im Folgenden anhand von Ausführungsbeispielen unter Bezugnahme auf die Zeichnung beschrieben; in dieser zeigen;
- Fig. 1: eine schematische Schnittdarstellung durch einen Drehgeber, der zur Erfassung des Drehwinkels einer Welle einen erfindungsgemäßen Magnetfeldsensor mit feststehendem Umlenkkörper umfasst, und
- Fig. 2: einen der Fig. 1 ähnlichen Schnitt durch einen Drehgeber, dessen Magnetfeldsensor einen sich mit der Welle mitdrehenden Umlenkkörper aufweist.

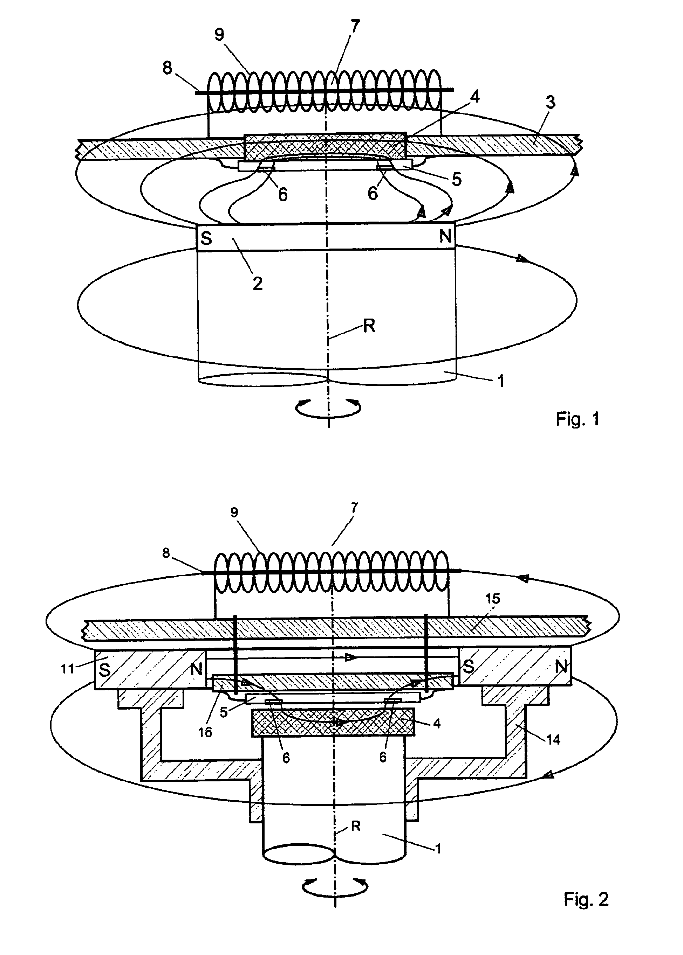

Es sei ausdrücklich darauf hingewiesen, dass die beiden Figuren 1 und 2 nicht maßstabsgetreu sind und dass sowohl die Größe der einzelnen Komponenten als auch ihre gegenseitigen Abstände der Deutlichkeit halber teilweise stark vergrößert wiedergegeben sind. Gleiche bzw. einender entsprechende Teile sind mit den gleichen Bezugszeichen versehen.

Die schematischen Darstellungen der Figuren 1 und 2 zeigen die wesentlichsten Komponenten eines Positionsgebers, der als so genannter Multiturn die Umdrehungen einer Welle 1 sowohl fein auflösen als auch deren Absolutzahl zählen kann.

In beiden Fällen kann die Welle 1 entweder der sich drehende Körper selbst sein, der durch den Drehgeber überwacht werden soll, oder sie kann mit diesem Körper so starr verbunden oder mechanisch gekoppelt sein, dass sie dessen Drehbewegung exakt abbildet.

Auf dem in Fig. 1 nach oben weisenden Stirnende der Welle 1 ist ein stabförmiger Permanentmagnet 2 so montiert, dass er sich mit der Welle 1 dreht, wobei die Drehachse R senkrecht durch die Mitte zwischen seinem Nord- und seinem Südpol verläuft.

Oberhalb des Permanentmagneten erstreckt sich ebenfalls senkrecht zur Drehachse R eine Platine 3, die aus einem nicht magnetischen Material besteht und die in ihrem Bereich oberhalb des Stirnendes der Welle 1 eine durchgehende Öffnung aufweist, in die ein plattenförmiger Umlenkkörper 4 aus ferromagnetischem Material eingesetzt ist, der in Richtung der Drehachse R eine größere Dicke aufweist, als die Platine 3.

Alternativ kann es sich bei der Öffnung auch um ein Sackloch handeln. Der plattenförmige Umlenkkörper kann auch ringförmig ausgebildet sein.

An der dem Stirnende der Welle 1 zugewandten ebenen Flachseite des Umlenkkörpers 4 liegt ein IC-Halbleiterbaustein 5 mit der Oberseite seines (nicht dargestellten) Gehäuses an.

In der nach unten weisenden Fläche des IC-Halbleiterbausteins 5 sind vier Hallelemente ausgebildet, von denen in der Schnittansicht der Fig. 1 jedoch nur zwei Hallelemente 6, 6 sichtbar sind, während ein drittes Hallelement hinter und ein viertes vor der Zeichenebene liegt.

Wie man sieht, werden einige der Magnetfeldlinien die vom Nord- zum Südpol des Permanentmagneten 2 verlaufen. durch den ferromagnetischen Umlenkkörper 4, der einen geringen magnetischen Widerstand besitzt, so umgelenkt, dass sie die vier Hallelemente 6 mit einer senkrechten Komponente durchsetzen, deren Größe sich bei einer Drehung der Welle 1 und des Permanentmagneten 2 gegenüber der feststehenden Platine 3 in Abhängigkeit vom jeweiligen Drehwinkel ändert, so dass die von den vier Hallelementen 6 abgegebenen Signale zur fein auflösenden Erfassung des Drehwinkels der Welle 1 verwendet werden können.

Auf ihrer Oberseite trägt die Platine 3 ein Wiegand-Modul 7, das im Wesentlichen aus einem hier horizontal angeordneten Wieganddraht 8 und einer auf ihn aufgewickelten Spule 9 besteht. Dieses Wiegand-Modul 7 dient in bekannter Weise dazu, Signalimpulse abzugeben, mit deren Hilfe die Umdrehungen der Welle 1 gezählt werden können. Diese Signalimpulse enthalten darüber hinaus ausreichend elektrische Energie, um zumindest für den für diese Zählung und die Speicherung des jeweils erreichten Zählwertes erforderlichen Teil der Verarbeitungselektronik die elektrische Arbeitsenergie zur Verfügung zu stellen, wenn die Versorgung mit Fremdenergie (, beispielsweise auch durch Abklemmen einer Batterie) ausfällt.

Die Anordnung ist so getroffen, dass sich die vier Hallelemente 6 möglichst nahe am Permanentmagneten 2 befinden, so dass sie von einem starken Feld durchsetzt werden, das zu hohen Ausgangssignalen führt, während das Wiegand-Modul 7 im Bereich des deutlich schwächeren Fernfeldes des Permanentmagneten 2 befindet, um zu vermeiden, dass es zu einer Sättigung des Wieganddrahtes 8 kommt.

Wesentlich an der Anordnung ist, dass der Umlenkkörper 4, der die vier Hallelemente 6 völlig überdeckt, zwischen den Hallelementen 6 und dem Wieganddraht 8 angeordnet ist, so dass er aufgrund seiner hohen magnetischen Leitfähigkeit das magnetische Eigenfeld des Wieganddrahtes 8 nahezu kurzschließt und dadurch die vier Hallelemente 6 weitgehend gegen Störeinflüsse durch dieses Magnetfeld schützt.

Wenn bei der in Fig. 1 gezeigten Anordnung eine bestimmte Art von Umlenkkörper 4 feststehend angeordnet ist, wird dieser durch die Drehung des Permanentmagneten 2 ständig ummagnetisiert, wobei in unvermeidlicher Weise eine Hysterese auftritt, die dazu führt, dass in den aus den Ausgangssignalen der Hallelemente abgeleiteten, zur Feinbestimmung der Winkelposition dienenden Signalen Sprünge auftreten, die zwar dadurch klein gehalten werden können, dass für den Umlenkkörper 4 ein Material gewählt wird, das eine sehr kleine Remanenz und eine sehr kleine Koerzitivkraft aufweist, die aber dennoch die maximal erreichbare Genauigkeit eines derartigen Positionsgebers begrenzen. Bei der erfindungsgemäßen Verwendung von Ferriten werden diese Sprünge, dessen Auswirkungen auf die Messgenauigkeit schon sehr gering sind, durch das Hystereserauschen verschliffen.

Will man eine solche auf der Hysterese bzw. des Hystereserauschens des Materials des Umlenkkörpers 4 beruhende Beeinträchtigung der Messsignale vollständig vermeiden, so kann man eine Anordnung gemäß Fig. 2 wählen, bei der der Umlenkkörper 4 mit dem Stirnende der sich drehenden Welle 1 so fest verbunden ist, dass er sich mit dieser und einer Permanentmagnetanordnung mitdreht, die hier von einem diametral magnetisierten Permanentmagnetring 11 gebildet wird, der über einen Träger 14 mit der Welle 1 drehfest verbunden ist. Dabei erstrecken sich seine miteinander fluchtenden Magnetisierungsrichtungen senkrecht zur Drehachse R, die durch die Mitte des Abstandes zwischen dem inneren Nordpol des Permanentmagnetringes 11 und dem ihm gegenüberliegenden inneren Südpol des gleichen Permanentmagneten verläuft. Anstelle eines Permanentmagnetringes können auch zwei voneinander getrennte Magnete verwendet werden.

Auch hier ist eine Trägerplatine 15 vorgesehen, deren axialer Abstand vom Stirnende der Welle 1 größer als der des Permanentmagnetringes 11 ist. Die Platine 15 trägt an ihrer der Welle 1 zugewandten Unterseite eine Hilfsplatine 16 aus nicht magnetischem Material, auf deren Unterseite wieder der (ohne das eigentlich vorhandene Gehäuse dargestellte) IC-Halbleiterchip 5 angeordnet ist, in dessen der Welle 1 und damit dem Umlenkkörper 4 zugewandten Fläche vier Hallelemente 6 ausgebildet sind, von denen auch hier nur zwei Hallelemente wiedergegeben sind.

Magnetfeldlinien aus dem Zentralfeld des Permanentmagnetringes 11 werden durch den Umlenkkörper 4 so umgelenkt, dass sie die vier Hallelemente 6 in etwa senkrecht durchsetzen.

Während bei feststehendem Umlenkkörper 4 darauf zu achten ist, dass zur Erzielung kleiner Hysteresefehler die Remanenz und damit µ_{R} klein sind, ist bei einem mitrotierenden Umlenkkörper 4 ein hohes µ_{R} erwünscht, um ein starkes Feld möglichst senkrecht abzusaugen und um durch die Welle 1 eindringende Fremdstörfelder, die man grundsätzlich nicht eliminieren kann, zu homogenisieren und senkrecht austreten zu lassen. Hier ist es besonders vorteilhaft, wenn der axiale Abstand der vier Hallelemente 6 vom Umlenkkörper 4 möglichst klein ist.

Auch hier ist ein Wiegand-Modul 7 vorgesehen, das aus einem Wieganddraht 8 und der auf diesen aufgewickelten Spule 9 besteht und zur Zählung der Umdrehungen der Welle 1 dient. Wie beim Ausführungsbeispiel der Fig. 1 befindet sich auch hier das Wiegand-Modul im deutlich schwächeren Fernfeld des Permanentmagnetringes 11.

Wesentlich an beiden Ausführungsformen ist, dass die aktiven Flächen der vier Hallelemente 6 in Draufsicht auf die IC-Oberfläche jeweils einen in etwa quadratischen Grundriss besitzen und gemeinsam eine Ebene aufspannen, in der sie auf den vier Ecken eines Quadrates angeordnet sind, dessen Kantenlänge ein Vielfaches der Kantenlänge der aktiven Flächen beträgt.

In beiden Fällen ist die Vertikalprojektion des Umlenkkörpers 4 in Richtung der Drehachse R auf die Ebene der aktiven Flächen der vier Hallelemente 6 größer als das von ihnen aufgespannte Quadrat und überdeckt dieses symmetrisch und vollständig. Bei dem in Fig. 1 dargestellten Drehgeber kann die erwähnte Vertikalprojektion einen beliebig symmetrischen, beispielsweise quadratischen Grundriss besitzen, während sie im Fall des Drehgebers in Fig. 2 vollkreisförmig oder kreisringförmig ist.

## Patentansprüche

1. Magnetfeldsensor mit wenigstens drei Hallelementen (6) für einen Positionsgeber, der eine Verarbeitungs- und Steuerelektronik für die Ausgangssignale des Magnetfeldsensors und eine Erreger-Permanentmagnetanordnung (2; 11; 12) umfasst, deren Magnetfeldrichtung mithilfe der Hallelemente (6) erfasst werden soll, wobei diese mit gegenseitigen Abständen in einem Halbleiter-IC (5) so ausgebildet und angeordnet sind, dass ihre aktiven Flächen in einer gemeinsamen, zur Oberfläche des Halbleiter-ICs (5) parallelen Ebene liegen, und mit einem einzigen, aus einem ferromagnetischen Material bestehenden Umlenkkörper (4), der so angeordnet ist, dass von der Permanentmagnetanordnung (2; 11; 12) ausgehende Feldlinien, die ohne den Umlenkkörper (4) parallel zur gemeinsamen Ebene der aktiven Flächen der Hallelemente (6) verlaufen würden, zumindest eine Richtungskomponente erhalten, welche diese aktiven Flächen senkrecht durchstößt,
**dadurch gekennzeichnet,**
**dass** der Umlenkkörper (4) als eigenständiges Bauteil getrennt vom Halbleiter-IC (5) gefertigt und montiert ist und
**dass** die gegenseitigen Abstände der Hallelemente (6) auf der Oberfläche des Halbleiter-ICs (5) ein Vielfaches der maximalen Ausdehnung der Hallelemente (6) selbst betragen.

2. Magnetfeldsensor nach Anspruch 1, **dadurch gekennzeichnet, dass** der Umlenkkörper (4) plattenförmig ausgebildet und so angeordnet ist, dass eine seiner ebenen Flächen der die Hallelemente (6) tragenden Oberfläche des Halbleiter-ICs (5) gegenüber liegt und zu dieser in etwa parallel verläuft.

3. Magnetfeldsensor nach Anspruch 1 oder 2, **dadurch gekennzeichnet, dass** der plattenförmige Umlenkkörper (4) auf dem Gehäuse des Halbleiter-ICs (5) angeordnet ist.

4. Magnetfeldsensor nach Anspruch 2 oder 3,, **dadurch gekennzeichnet, dass** die ebene Fläche des plattenförmigen Umlenkkörpers (4), die der die Hallelemente (6) tragenden Oberfläche des Halbleiter-ICs (5) gegenüber liegt, die aktiven Flächen der Hallelemente (6) vollständig überdeckt.

5. Magnetfeldsensor nach Anspruch 4, **dadurch gekennzeichnet, dass** die Fläche des plattenförmigen Umlenkkörpers (4), die der die Hallelemente (6) tragenden Oberfläche des Halbleiter-ICs (5) gegenüber liegt, diese Oberfläche des Halbleiter-ICs (5) vollständig überdeckt.

6. Magnetfeldsensor nach Anspruch einem der Ansprüche 2 bis 5, **dadurch gekennzeichnet, dass** der plattenförmige Umlenkkörper (4) in eine Öffnung in einer die elektronischen Bauteile des Magnetfeldsensors tragenden Platine (3) eingesetzt ist.

7. Magnetfeldsensor nach einem der vorhergehenden Ansprüche, **dadurch gekennzeichnet, dass** der Umlenkkörper (4) in der zur Oberfläche des Halbleiter-ICs (5) senkrechten Richtung eine Dicke von mindestens 0,2 mm besitzt.

8. Magnetfeldsensor nach einem der vorhergehenden Ansprüche, **dadurch gekennzeichnet, dass** das Material des Umlenkkörpers (4) eine kleine Remanenz aufweist.

9. Magnetfeldsensor nach einem der vorhergehenden Ansprüche, **dadurch gekennzeichnet, dass** das Material des Umlenkkörpers (4) eine kleine Koerzitivkraft aufweist.

10. Magnetfeldsensor nach einem der vorhergehenden Ansprüche, **dadurch gekennzeichnet, dass** das Material des Umlenkkörpers (4) aus Ferrit besteht.

11. Magnetfeldsensor nach einem der Ansprüche 1 bis 10, **dadurch gekennzeichnet, dass** er als Drehgeber zur Erfassung der Winkelposition einer sich drehenden Welle (1) aufgebaut ist, die eine symmetrisch zu ihrer Rotationsachse (R) montierte und sich mit ihr mitdrehende Erreger-Permanentmagnetanordnung (2; 11) trägt.

12. Magnetfeldsensor nach Anspruch 11, **dadurch gekennzeichnet, dass** ihm ein Wiegandmodul (7) zugeordnet ist, das zur Erfassung der absoluten Umdrehungszahl dient.

13. Magnetfeldsensor nach Anspruch 12, **dadurch gekennzeichnet, dass** der Umlenkkörper (4) bezüglich des Halbleiter-ICs (5) fest stehend zwischen der Ebene der aktiven Flächen der Hallelemente (6) und dem Wiegandmodul (7) angeordnet ist, um dessen ansonsten die Hallelemente (6) störendes Eigenfeld kurzzuschließen.

14. Magnetfeldsensor nach Anspruch 12, **dadurch gekennzeichnet, dass** der Umlenkkörper (4) auf der sich drehenden Welle (1) so montiert ist, dass er sich mit ihr dreht, wobei seine senkrechte Projektion auf die die Hallelemente (6) tragende Oberfläche des Halbleiter-ICs (5) kreisförmig ist
